Europäisches Patentamt

(19) European Patent Office  (11) Publication number: **0 000 244**

Office européen des brevets  **B1**

(12) **EUROPEAN PATENT SPECIFICATION**

(21) Application number: **78300020.1**  (51) Int. Cl³: **H 01 L 23/36,**
**H 01 L 23/46, H 01 L 23/42**

(22) Date of filing: **06.06.78**

(54) Apparatus for cooling heat generating electrical components

(30) Priority: **16.06.77 US 807096**

(43) Date of publication of application:
**10.01.79 Bulletin 79/01**

(45) Publication of the grant of the European patent:
**23.07.80 Bulletin 80/15**

(84) Designated Contracting States:
**DE FR GB**

(56) References cited:
**IBM Technical Disclosure Bulletin
vol. 18 October 1975, New York
S.P. Antippas: "Cooling cap for
powder or liquid filled modules"
pages 1387 - 1388
IBM Technical Disclosure Bulletin
vol. 19 January 1977, New York
A. H. Bauman et al. "Multimodule
heat sink", pages 2976 - 2977**

(73) Proprietor: **International Business Machines
Corporation
Armonk, N.Y. 10504 (US)**

(72) Inventor: **Simons, Robert Edward
16 Shamrock Circle
Poughkeepsie, New York 12603 (US)**

(74) Representative: **Lewis, Alan J
IBM United Kingdom Patent Operations
Hursley Park
Winchester, Hants, SO21 2JN (GB)**

Courier Press, Leamington Spa, England.

## Apparatus for cooling heat generating electrical components

The invention relates to cooled electrical apparatus, that is electrical apparatus comprising a heat generating electrical component or components, a heat sink and a heat transfer path for transferring heat from the or each component to the heat sink.

With the miniaturized capabilities afforded by the discovery of solid state electronics, various means of dissipating the heat generated by solid state components have been investigated. The standard forced air convection means appears to have reached its limit of practicality in that the amount of air that is required to provide sufficient cooling for the limited heat dissipating surfaces introduces a noise problem, and without some auxiliary techniques cannot maintain each of a large number of components within its operating temperature range. Accordingly, especially in connection with large scale computer systems, cooling systems have been used in which one or more heat dissipating electronic components are contained in a special cooling environment such as a low boiling point liquid or a gas.

U.S. specification No. 3,993,123 shows an example of electrical apparatus comprising a module including one or more heat generating electrical components mounted on a substrate. A heat conductive cap is sealed to the substrate and encloses the heat generating components. The wall of the cap opposite the substrate contains elongated openings therein extending towards the heat generating components and on the same centres with respect thereto. A resilient member is located in each opening in the cap and acts against the inner end of the opening. A thermal conductive element is located in each of the openings and is of a size to leave only a small peripheral gap between the peripheral opening wall and the associated thermal conductive element. Each resilient member urges its thermal conductive element into heat conducting pressure contact with the aligned heat generating component. A thermal conductive inert gas is located within the cap filling the peripheral gaps and any spaces in the interfaces between the heat generating elements and thermal conductive elements. The heat is removed from the cap by external heat removal means e.g. a heat sink.

The conduction cooling scheme of U.S. specification No. 3,993,123 is very efficient and keeps the electronic components to be cooled operating within their specified thermal limits. However, when low-powered chips are included with high-powered chips on the same substrate within the same module, the cooling is too efficient for the low-power electronic components. That is, the low-power electronic components are essentially over-cooled such that they are maintained below their minimum operating temperature limit.

An article entitled "Cooling Cap for Powder or Liquid Filled Modules" appearing on pages 1387—88 of the IBM Technical Disclosure Bullentin Vol 18 No 5 October 1975, discloses another example of electrical apparatus comprising a module including one or more heat generating electrical components mounted on a substrate. A heat conductive cap is sealed to the substrate and encloses the heat generating components to enhance heat transfer between the components and the cap, a series of similar conducting studs are soldered to the cap in line with the components and extend within the cap to reach to within a short distance of each component. The space within the cap is filled with a conducting powder to increase heat transfer from the components to the studs and to the cap.

The apparatus disclosed in the TDB article has the same limitation as the apparatus disclosed in the aforesaid U.S. specification No. 3,993,123. This is that the cooling paths for all the components are similar and consequently variations in the power consumptions of the components cause variations in their operating temperatures.

United States specification No. 3,128,419 relates to individual semi-conductor devices, such as rectifiers and transistors and is concerned with the problem caused by the differential expansion between such devices and the mountings to which they are area soldered. The solution disclosed in U.S. specification No. 3,128,419 consists in providing an expansion equalizing plate between the device and its mounting. The plate consists of a multiplicity of cylindrical copper wire pieces held together by a ring. The specification points out, as a positive disadvantage, that the plate reduces the thermal conductance between the device and its mounting but states that the increase in working temperature of the device can be accepted.

The present invention is concerned with the above problem of over cooling low-powered electrical components when a module containing both high-powered and low-powered electrical components is subject to one and the same cooling system. The problem is overcome by the invention by providing predetermined thermal transmission characteristics to the cooling system such that one and the same system is suitable for cooling a module containing both high-powered and low-powered components at the same time.

The invention therefore provides electrical apparatus comprising a member through which heat from a plurality of heat generating electrical components is conducted to an interface with a heat sink, said components having different power ratings and generating different quantities of heat in use, characterised in that the interface comprises a thermal adapter positioned in the heat transfer path from the member to the heat sink selectively to introduce different thermal resistances into the individual heat conduction paths from the individual components to the heat sink, said adapter comprising a sheet or other planar device having a first pattern of zones introducing a thermal resistance of a first value into the heat conduction paths through those first zones and a second pattern of zones introducing a thermal resistance of a second and different value into the heat conduction paths through those second zones.

One way of carrying out the claimed invention will now be described in detail by reference to an example of electrical apparatus embodying the invention and illustrated in the accompanying drawings, in which:—

FIGURE 1 is a schematic cros-sectional view of a cooling module forming part of the electrical apparatus embodying the invention,

FIGURE 2 is a schematic representation showing a plan view of a substrate and its supporting flange with the low-powered and high-powered chips to be cooled grouped thereon,

FIGURE 3 is a plan view of a thermal interface adapter having cut-outs for temperature control of low-powered chips grouped as in Figure 2,

FIGURE 4 is a schematic representation showing the cross-sectional view taken along the line IV—IV of Figure 3 and symbolically showing the heat transfer path across the interface adapter within the module,

FIGURE 5 is a graph showing the thermal inter-face resistance against the contact area of a thermal interface adapter in a module,

FIGURE 6 is a graph showing the thermal interface resistance against the contact area for different thermal interface adapter materials.

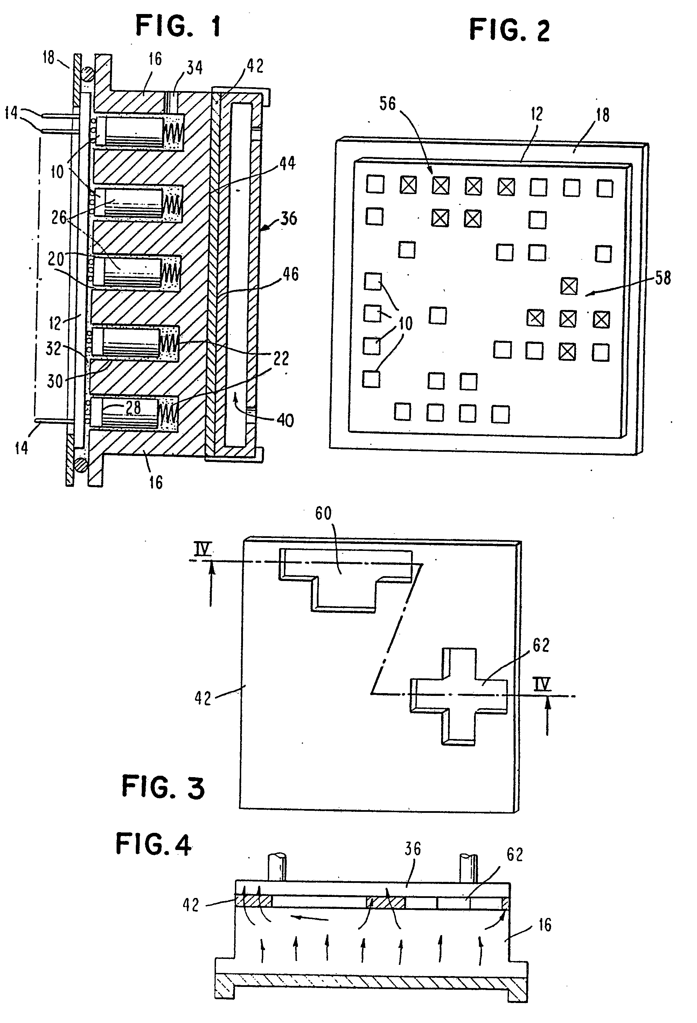

Referring to Figure 1, there is shown a cross-sectional view of a gas encapsulated module for providing cooling of heat generating electrical or electronic components shown in the form of chips 10. The chips 10 are integrated circuit components and consist of solid state circuits and devices which are densely packed on a semi-conductor substrate. The power consumed in the circuits within a chip generates heat which must be removed from the chip. Since the various circuits have different power requirements and thus generate different amounts of heat, and since the integrated components thereon must be maintained within certain temperature ranges for reliable operation, the cooling must be of such character as to maintain the temperature of each chip within the required operating range.

The chips 10 are mounted on one side of a substrate 12, generally made of ceramic, which has pins 14 extending from the other side thereof, these connecting pins 14 permit the module to be plugged into a board (not shown) which may very well carry auxiliary circuits, etc. A cap or housing 16 is attached to the substrate 12 by means of a flange 18 which surrounds the periphery of the substrate 12. The cap 16 is made of a good heat conductive material such as copper or aluminium. The cap 16 is sufficiently thick to provide openings opposite each of the closely spaced chips 10. Springs 22 are located at the inner end of each of the openings 20 and provide a spring force against a piston element 26 located in the opening 20. The spring force gives the piston element 26 a predetermined force at the outer end thereof where it contacts the back surface of the electronic chip 10 to be cooled. A small annular gap 30 exists between the circumference of the piston element 26 and the sidewalls of the hole 20 in the cap 16. The gap 30 is sufficiently wide to allow a little play of the element 26 within the hole 20 so that the element 26 can attain relatively flat surface engagement with the chip 10. It should be noted that the thermal conductive piston element 26 can accommodate chips 10 of various heights because of the resiliency of the spring member 22. Helium gas 32 is introduced into the open space between the substrate 12 and the cap 16. Helium gas is utilized for several reasons. The gas has a low molecular weight and thus easily fills any voids or spaces in the interface 28 between the thermal conductive piston elements 26 and the chips 10. Similarly the helium gas 32 fills the gap 30 between the periphery of the thermal conductive piston element 26 and the wall of the hole 20 thus forming a gaseous thermal conductive interface. Helium gas is a good thermal conductor and therefore provides an interface having high heat conductivity. That is, the interfaces formed using helium gas have a relatively low thermal resistance. Another feature of helium gas is that it is inert. By inert it is meant that the gas is electrically non-conductive, non-poisonous, non-corrosive, non-flammable, non-explosive and non-toxic. Helium gas also has a high adhesion quality that essentially wets the surface with which it is in contact. Other suitable low-molecular weight gases such as hydrogen or carbon dioxide could be used. As aforesaid any voids in the pressure interface 28 are filled by the thermal conductive inert gas so that the interface provides a low-resistance to heat transfer. The gap 30 around the periphery of the thermal conductive elements 26 contains helium gas which provides a good thermal interface. As discussed above, the module is designed to obtain the required heat transfer rate to maintain all the chips 10 within their specified operating ranges. The heat accumulated in the thermal conductive material cap 16 via the thermal conductive elements 26, is transferred to a cold plate 36 which is attached to the cap 16. As can be seen from Figure 1, the surface of the cap 16 is relatively flat so that the cold plate 36 can be attached thereto in good thermal conductive relation. The cold plate 36 has a cooling liquid 40 circulated therethrough which removes the heat transferred to the cold plate.

The heat transfer path for removing heat from the heat generating electronic component chips 10 is across the interfaces 28 between the chips 10 and the piston conductive elements 26, through the piston conductive elements 26 and across the interface 30 between the circumference of these elements and the walls of the openings 20 within the cap 16. The heat is then conveyed through the cap 16 and through the interface between the top of the cap 16 and the wall of the cold plate 36. The heat moves through the wall of the cold plate 36 into the liquid 40 which flows through the cold plate 36 which is the ultimate heat sink.

As stated the rate of heat removal must be such as to keep the electronic components or chips 10 within their thermal operating range. We have found that low-power chips are maintained below their specified minimum operating temperature limit since those chips do not generate sufficient heat to reach their operating temperature when subject to the good thermal heat transfer path needed by high-power chips. This problem is solved in the present example by including a thermal adapter 42 between the top of the cap 16 and the cold plate 36. The adapter 42 is provided by a plate formed of material having a relatively high thermal conductivity i.e. high in relation to air. The adapter plate 42 will be described hereinafter with particular reference to Figures 3 and 4.

Figure 2 shows a combination of low-power and high-power chips 10 to be cooled within the same module and Figure 3 shows the plate 42. The low-power chips are designated with an X drawn therethrough and the high-power chips just by squares. It can be seen that the low-power chips are arranged in groups 56, and 58 on the substrate 12. A higher resistance heat path in the module adjacent to the low-power chips groupings is obtained by including a thermal interface adapter, provided by plate 42, which has cut-out portions 60 and 62 therein of the same shape and location as the low-power chip groupings 56 and 58 on the substrate 12. As can be seen from Figure 3, these cut-outs 60, 62 will be in the direct thermal path associated with the low-power chip groupings 56, 58 and introduce a higher thermal resistance in the path which will cause the low-power chips to operate at a higher temperature so as to be above the minimum operating temperature thereof.

Referring back to Figure 1, the inclusion of a thermal adapter 42 between the top of the cap 16 and the cold plate 36, creates an interface 44 between the top of the cap 16 and the adapter 42 and a further interface 46 between the top of the adapter 42 and the cold plate 36. The interfaces 44, 46 and the adapter 42 introduce thermal resistance in the heat path between the cap 16 and the cold plate 36. The ratio of the thermal resistance of the heat paths through the material of the adapter and through the medium in the apertures depends on the material from which the adapter is made. The thermal interface adapter can be made of a number of different materials, such as poor heat conductors polycarbonate, polytetrafluorethylene, mica or good heat conductors stainless steel aluminium etc.

Figure 4 is a schematic diagram showing a cross-section view taken along the zig-zag line IV—IV of Figure 3. The adapter 42 is shown within the module and the heat transfer flow is represented by arrows. As can be seen, the heat does not pass through the cut-out portions but is conducted through the cap or housing to the contact areas between the cap or housing and the thermal interface adapter before passing to the cold plate. The thermal resistance of the heat transfer path is increased by the introduction of the cut-out areas and, accordingly, the low-power chips adjacent the cut-out portions operate at a higher temperature due to the higher resistance path which must be followed because of the cut-out portions in the thermal interface adapter within the heat transfer path.

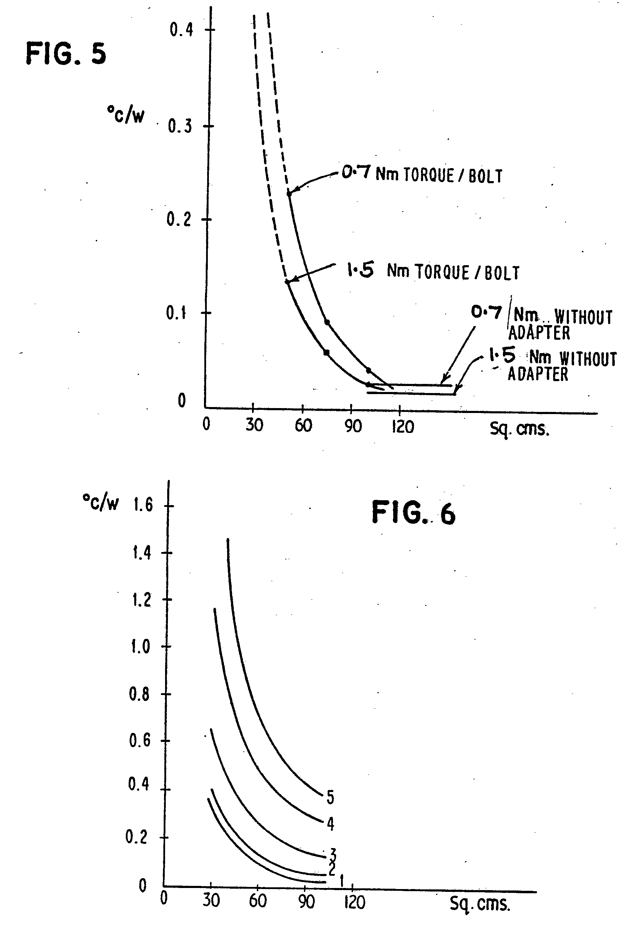

The effect of thermal interface adapters on interface resistance is shown in Figure 5 where the thermal interface resistance in degrees Celsius per Watt versus contact area in square centimeter is plotted. Figure 5 is plotted for a 100% contact area of the thermal interface adapter, which would be 111 x $10^{-4}$ sq.m., and is intended simply to illustrate the effect of contact pressure. The two curves shown represent two different torques applied to the bolts holding the thermal interface adapter to the module housing. One curve is identified as a 1.5Nm (Newton meter) torque per bolt while the other is identified as 0.7 Nm torque per bolt. It can be seen from the curves in Figure 5 that the thermal interface resistance increases sharply as the contact area decreases.

Figure 6 is similar to Figure 5 and is intended simply to illustrate the effect of material on thermal interface adapter performance. The graph shows the thermal interface resistance in degrees Celsius per Watt versus the contact area in square centimeters. The curves in descending order represent polycarbonate, polytetrafluoroethylene, mica, stainless steel and aluminium. From the curves it can be seen that polycarbonate gives the highest overall thermal interface resistance. A polycarbonate adapter, 7.6 x $10^{-4}$m thick with 90 square centimeters of contact area has an interface resistance of 0.5°C per watt. A polytetrafluoroethylene adapter, 7.6 x $10^{-4}$m thick with 68 square centimeters of contact area provides an interface resistance of 9.5°C per watt or mica adapter 7.6 x $10^{-4}$m thick with 42 square centimeters of contact area provides an interface resistance of 0.5°C per watt.

The invention is not limited to the cold plate 36 type of heat sink for exterior heat removal, and in fact could employ an air cooled heat sink.

## Claims

1. Electrical apparatus comprising a member through which heat from a plurality of heat generating electrical components is conducted to an interface with a heat sink, said components having different power ratings and generating different quantities of heat in use, characterised in that the interface comprises a thermal adapter (42) positioned in the heat transfer path from the member to the heat sink selectively to introduce different thermal resistances into the individual heat conduction paths from the individual components to the heat sink, said adapter comprising a sheet or other planar device having a first pattern of zones introducing a thermal resistance of a first value into the heat conduction paths through those first zones and a second pattern of zones introducing a thermal resistance of a second and different value into the heat conduction paths through those second zones.

2. Electrical apparatus as claimed in claim 1, further characterised in that the first pattern of zones is provided by a pattern of apertures cut through the adapter and the second pattern of zones is provided by the remaining portions of the adapter.

3. Electrical apparatus as claimed in claim 2, further characterised in that the adapter is made of polycarbonate, polytetrafluoroethylene or mica.

4. Electrical apparatus as claimed in claim 2, further characterised in that the adapter is made of stainless steel or aluminium.

## Patentansprüche

1. Elektrische Vorrichtung mit einem Bauelement, über das Wärme von einer Anzahl wärmeerzeugender elektrischer Bauteile nach einer Trenn- oder Berührungsfläche mit einer Wärmesenke ableitbar ist, wobei diese Bauteile unterschiedliche Nennleistungen aufweisen und im Betrieb unterschiedliche Wärmemengen erzeugen, dadurch gekennzeichnet, daß in dem von dem Bauelement nach der Wärmesenke führenden Wärmeableitpfad an der Trennfläche ein Wärmeübertragungs-Adapter (42) vorgesehen ist der für die einzelnen von den elektrischen Bauteilen nach der Wärmesenke führenden Wärmeableitpfade unterschiedliche Wärmeableitwiderstände darstellt, und daß dieser Wärmeübertragungs-Adapter aus einer Folie oder Platte besteht, die ein erstes Muster aus Zonen enthält, die für die durch diese ersten Zonen führenden Wärmeableitpfade einen ersten Wärmewiderstandswert darstellen, sowie ein zweites Muster aus Zonen enthält, die für die durch diese zweiten Zonen führenden Wärmeableitpfade einen zweiten unterschiedlichen Wärmewiderstandswert darstellen.

2. Elektrische Vorrichtung nach Anspruch 1, dadurch gekennzeichnet, daß das erste Muster von Zonen durch ein Muster von in dem Adapter vorgesehenen Offnungen gebildet ist und daß die übrigen Teile des Adapters das zweite Muster von Zonen bilden.

3. Elektrische Vorrichtung nach Anspruch 2, dadurch gekennzeichnet, daß der Adapter aus Polycarbonat, Polytetrafluoraethylen oder Glimmer besteht.

4. Elektrische Vorrichtung nach Anspruch 2, dadurch gekennzeichnet, daß der Adapter aus rostfreiem Stahl oder Aluminium besteht.

## Revendications

1. Appareil électrique comportant un élément par l'intermédiaire duquel la chaleur produite par plusieurs composants électriques est transmise à un puits de chaleur à travers un interface, lesdits composants présentant différentes puissances et dissipant différentes quantités de chaleur en cours d'utilisation, caractérisé en ce que l'interface comprend un adapteur thermique (42) placé dans le chemin de transfert de chaleur allant dudit élément au puits de chaleur de façon à introduire de façon sélective différentes résistances thermiques dans les différents chemins de conduction de chaleur allant des différents composants au puits de chaleur, ledit adaptateur comprenant une feuille ou autre dispositif planaire comportant une première configuration de zones introduisant une résistance thermique d'une première valeur dans les chemis de conduction de chaleur traversant ces premières zones et une seconde configuration de zones introduisant une résistance thermique d'une seconde valeur, différente de la première, dans les chemins de conduction de chaleur traversant ces secondes zones.

2. Appareil électrique selon la revendication 1, caractérisé en outre en ce que la première configuration de zones se compose d'une configuration d'ouvertures pratiquées dans l'adaptateur et en ce que la seconde configuration de zones se compose des parties restantes de l'adaptateur.

3. Appareil électrique selon la revendication 2, caractérisé ne outre en ce que l'adaptateur est en polycarbonate, en polytétrafluoréthylène ou en mica.

4. Appareil électrique selon la revendication 2, caractérisé en outre en ce que l'adaptateur est en acier inoxydable ou en aluminium.

**FIG. 1**

**FIG. 2**

**FIG. 3**

**FIG.4**

0 000 244

FIG. 5

FIG. 6

Sq. cms.

2